(19) Europäisches Patentamt
European Patent Office
Office européen des brevets

(11) Publication number: **0 496 334 A1**

(12) **EUROPEAN PATENT APPLICATION**

(21) Application number: **92100875.1**

(51) Int. Cl.$^5$: **B32B 15/01**

(22) Date of filing: **20.01.92**

(30) Priority: **23.01.91 JP 22818/91**

(43) Date of publication of application:
**29.07.92 Bulletin 92/31**

(84) Designated Contracting States:
**DE FR GB**

(71) Applicant: **CHISSO CORPORATION**
**6-32, Nakanoshima 3-chome Kitaku**
**Osaka(JP)**

(72) Inventor: **Yano, Hitoshi**
**17, Tatsumidaihigashi 2-chome**
**Ichiharashi, Chibaken(JP)**
Inventor: **Hase, Hiroaki**
**17, Tatsumidaihigashi 2-chome**
**Ichiharashi, Chibaken(JP)**
Inventor: **Kikuta, Kazutsune**
**8890, Goi**
**Ichiharashi, Chibaken(JP)**

(74) Representative: **Hansen, Bernd, Dr.rer.nat. et al**
**Hoffmann, Eitle & Partner Patentanwälte**
**Arabellastrasse 4 Postfach 81 04 20**
**W-8000 München 81(DE)**

(54) **A flexible base laminated with metal on both the surfaces and a process for producing same.**

(57) A flexible base laminated with a metal on both the surfaces thereof having a structure of metal foil/polyimide/metal foil and also having superior adhesiveness, dimensional stability, heat resistance and electrical characteristics, and a process for producing the flexible base easily and continuously are provided, which flexible base is obtained by coating on a metal foil, a polyimide precursor solution which, after imidized, affords a resin having a specified coefficient of linear thermal expansion, followed by drying, further coating on the surface of the dried material of the solution, a polyimide precursor solution which, after imidized, affords a resin having a specified glass transition point, heating to imidize both the precursors and thereby obtain a base laminated with a metal on one surface, the two polyimide precursors being selected so that the polyimide laminate can have a specified coefficient of linear thermal expansion, and subjecting another metal foil to thermal contact bonding onto the resin surface obtained above.

EP 0 496 334 A1

## BACKGROUND OF THE INVENTION

### 1. Field of the Invention

This invention relates to a flexible base laminated with a metal on both the surfaces thereof, composed of metal foil/polyimide/metal foil and having a superior adhesion, dimensional stability, heat resistance and electrical characteristics, and a process for producing the same.

### 2. Description of the Prior Art

As the flexible polyimide base having a metal foil on both the surfaces thereof and used for printed circuit, a product obtained by laminating a metal foil onto both the surfaces of a polyimide film by the medium of an adhesive has so far been mainly used.

However, since such a base uses an adhesive between the polyimide film and the metal foil, the characteristics of the base depend upon the properties of the adhesive; hence a problem has been raised that such a product is inferior in the heat resistance, chemical resistance, humidity resistance, flexibility, etc.

On the other hand, in order to solve such a problem, a process has been proposed wherein two bases each having copper laminated on one surface thereof are laminated onto each other with an adhesive (Japanese patent application laid-open Nos. Sho 55-153,393 and Sho 64-18,294), but such a process, too, has raised a similar problem to the above due to use of an adhesive.

In order to solve these problems, an improved process has been proposed wherein a polyimide film is adhered directly onto a metal foil by heat pressing method (Japanese patent application laid-open No. Sho 57-181,857 and Japanese patent publication No. Sho 61-15,825).

This improved process uses no polyimide adhesive so that the heat resistance, electrical characteristics, etc. are improved, but since the process passes through a film preparation step, the same number of steps or more as compared with those for conventional processes are required. Further, by introducing a flexible structure into the molecular chain of polyimide to thereby promote pseudoplastization at a temperature of Tg or higher, improvement in the adhesion of polyimide film onto copper foil has been attempted, but a problem has been raised that the difference between the coefficient of thermal expansion of copper and that of polyimide resin increases so that the dimensional stability becomes inferior. To the contrary, if a resin having a coefficient of thermal expansion corresponding to that of copper foil is used, a problem has been raised that the adhesion strength between copper and the resin lowers.

## SUMMARY OF THE INVENTION

The object of the present invention is to provide a flexible base laminated with a metal on both the surfaces thereof, having a structure of metal foil/polyimide/metal foil and having superior adhesion and dimensional stability and also having superior heat resistance and electrical characteristics, and a process for producing such a flexible base easily and continuously.

The present invention resides in:

(1) A flexible base laminated with a metal on both the surfaces thereof, comprising a resin layer consisting of two laminated polyimide layers formed directly between two metal conductive foils,

the first layer of said two laminated polyimide layers having a coefficient of linear thermal expansion of about $0.1 \times 10^{-5}$ to $2.0 \times 10^{-5}/°C$,

the second layer thereof having a glass transition point (Tg) of about 250 to 400°C as measured according to thermomechanical analysis (hereinafter referred to as TMA) and

the polyimide laminated having a coefficient of linear thermal expansion of about $1.0 \times 10^{-5}$ to $3.0 \times 10^{-5}/°C$.

(2) A process for producing a flexible base laminated with a metal on both the surfaces thereof according to item (1), comprising firstly coating onto a metal conductive foil, a solution of a polyimide precursor which, after imidized, affords a resin having a coefficient of linear thermal expansion of about $0.1 \times 10^{-5}$ to $2.0 \times 10^{-5}/°C$, followed by drying the resulting laminate, coating onto the dried laminate, a solution of another polyimide precursor which, after imidized, affords a resin having a Tg of about 250° to 400°C as measured according to TMA, imidizing the resulting laminate by heat treatment to prepare a flexible base laminated with a metal on one surface thereof, the above-mentioned two kinds of the polyimide precursors being chosen so that the thus obtained polyimide laminate may have a coefficient of linear thermal expansion of about $1.0 \times 10^{-5}$ to $3.0 \times 10^{-5}/°C$, and subjecting the resin surface of the resulting base to thermal contact bonding onto another metal conductive foil.

(3) A process according to item (2), wherein said thermal contact bonding is continuously carried out according to roll-to-roll system by means of a roll press.

DETAILED DESCRIPTION OF PREFERRED EMBODIMENT

The coefficient of linear thermal exPansion referred to herein means a value sought by dividing the expanded length of a material from 100 ° C up to 250 ° C by a length or the material at 25 ° C and 150 ° C ( = 250 ° C-100 ° C).

The constitution and effectiveness of the present invention will be described below in more detail.

The polyimide ultimately formed on the metal conductive foil is composed essentially of the structural unit expressed by the following formula (I):

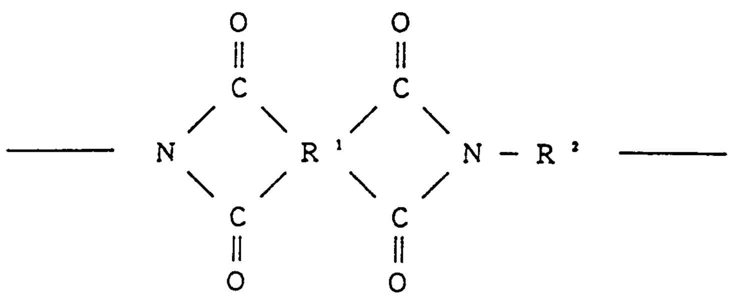

( I )

wherein $R^1$ represents a tetravalent organic group and $R^2$ represents a divalent organic group.

The structural unit of the formula (I) may be usually obtained by subjecting a polymer (polyamic acid) composed essentially of the structural unit expressed by the following formula (II), to heating dehydration and curing:

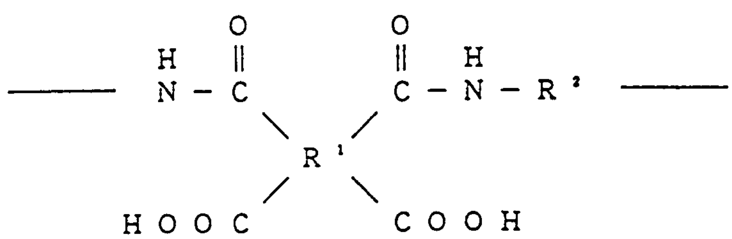

(II)

Further, the above structural unit may also be obtained by subjecting a partially (about 90 molar % or less) imidized substance of the polyamic acid, to heat-curing. Such polyamic acid, its partially imidized substance, etc. are referred to as polyimide precursor.

$R^1$ refers particularly to a tetravalent aliphatic group, alicyclic group, carbocyclic aromatic group, heterocyclic group, etc. of 2 or more carbon atoms.

$R^1$ may be unsubstituted or substituted by for example, halogen atom (e.g. F, Cℓ or Br) or one or more of alkyl groups of 1 to 4 carbon atoms, etc.

In the case where $R^1$ represents a carbocyclic aromatic group, this group has preferably at least one six-membered ring. $R^1$ refers particularly to monocyclic aromatic group, fused polycyclic aromatic group or polycyclic aromatic group having several fused rings or non-fused rings (these rings being linked to one another, directly or by the bridge linkage of divalent group).

As the above crosslinking group, for example the following groups are suitable:

$-O-$, $-CH_2-CH_2-$, $-CH_2-$, $-CH=CH-$,

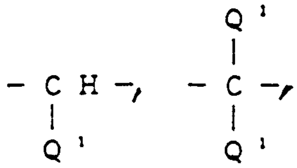

$-C_3F_6-$, -S-S-, -SO-, $-SO_2-$,

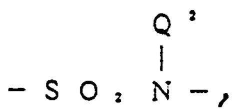

-CO-,

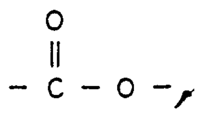

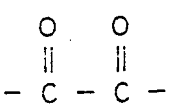, 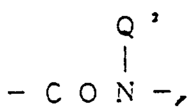, 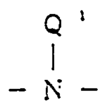, 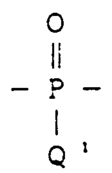, 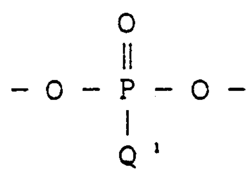,

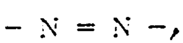, 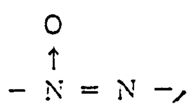, 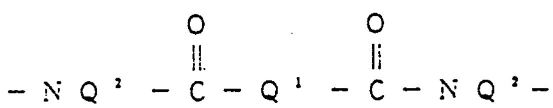,

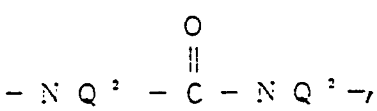, 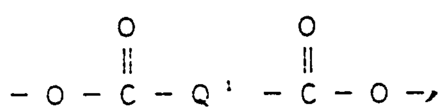,

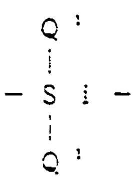 or 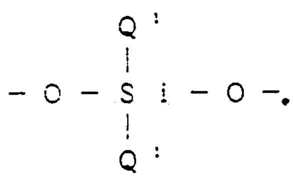.

In the above formulas, Q[1] represents an alkyl group or an alkylene group of 1 to 6 carbon atoms, preferably 1 to 4 carbon atoms, substituted, in some case, by at least one halogen atom (preferably F atom) or a cycloalkyl group, aryl group or arylene group.

Q[2] represents hydrogen atom, cycloalkyl group or aryl group, and in some case, an alkyl group of 1 to 4 carbon atoms substituted with at least one halogen atom.

Further, $Q^1$ and $Q^2$ each may be a group having the above groups linked to each other by way of two bridge linkage groups such as two $-SO_2-$ groups.

In the case where $R^1$ represents a heterocyclic group, particular examples thereof are a five or six-membered ring heterocyclic aromatic group containing oxygen, nitrogen and/or sulfur or a fused cyclic group thereof to benzene nucleus.

The carbocyclic aromatic group or heterocyclic group represented by $R^1$ may be those substituted with at least one group of nitro group, an alkyl group of 1 to 4 carbon atoms, trifluoromethyl group, a halogen atom (particularly, F atom), silyl group and sulfamoyl group, etc.

In the case where $R^1$ represents an aliphatic group, particular examples thereof are a linear saturated hydrocarbon group of 2 to 12 carbon atoms or a linear saturated hydrocarbon group in which a hetero atom such as O, S or N atom intervenes in the hydrocarbon chain.

In the case where $R^1$ represents an alicyclic group, exmaples thereof are cyclobutane group, methyl-substituted cyclobutane group, cyclohexane group, dicyclohexane group, etc.

As to $R^1$, it is preferred that the respective $R^1$s independently to each other represent a non-substituted monocyclic aromatic group, non-substituted fused polycyclic aromatic group or non-substituted fused bicyclic aromatic group. The last mentioned group is a group having two aromatic rings linked to each other by the medium of a crosslinking group of -O- or -CO-.

$R^2$ refers particularly to a divalent aliphatic group of 2 or more carbon atoms, alicyclic group, araliphatic group, carbocyclic aromatic group, heterocyclic group, organopolysiloxane group expressed by the following formula (III):

$$-R^3-(\underset{R^6}{\overset{R^5}{\mid}}\!\!\!\!\underset{\mid}{Si}O)_m-\underset{R^8}{\overset{R^7}{\mid}}\!\!\!\!\underset{\mid}{Si}-R^4- \qquad (III)$$

In the above formula (III), $R^3$ and $R^4$ each represent the same or different lower alkylene group or phenylene group and $R^5$, $R^6$, $R^7$ and $R^8$ each represent the same or different lower alkyl group, lower alkoxy group, phenyl group or phenoxy group and m represents an integer of 1 to 100.

The group expressed by $R^2$ may be those unsubstituted or substituted with a halogen atom such as F, Cℓ or Br, or with at least one alkyl group or alkoxy group of 1 to 4 carbon atoms.

In the case where $R^2$ represents a carbocyclic aromatic group, preferable examples thereof are monocyclic aromatic group, fused polycyclic aromatic group or non-fused bicyclic aromatic group. In the case of the non-fused bicyclic group, aromatic rings are linked to each other by the bridge linkage of divalent group. In this case, the enabling crosslinking group is the same as those exemplified in the description of $R^1$. In the case where $R^2$ represents a heterocyclic group, it is a five-membered or six-membered heterocyclic aromatic group containing O, N and/or S.

Further, when $R^2$ represents an aliphatic group, particular examples are an alkylene group of 2 to 12 carbon atoms or an alkylene group in which a hetero group such as O, S or N atom intervenes in the alkylene chain thereof.

When $R^2$ is an alicyclic group, examples thereof are cyclohexyl group, dicyclohexylmethane group, etc. On the other hand, when $R^2$ is an aromatic aliphatic group, particular examples are 1,3-, 1,4- or 2,4-bis-alkylenebenzene group, 4,4'-bis-alkylene-diphenyl group and 4,4'-bis-alkylene-diphenyl ether group.

As to $R^2$, preferable examples thereof are monocyclic aromatic group or non-fused bicyclic aromatic group wherein the respective $R^2$s are independent to each other or in some case, have as substituent, halogen atom or at least one alkyl group or alkoxy group of 1 to 4 carbon atoms, or a non-substituted aliphatic group of 2 to 10 carbon atoms.

Examples of the lower alkylene group expressed by $R^3$ and $R^4$ in the above formula (III) are alkylene groups of 1 to 6 carbon atoms such as methylene group, ethylene group, trimethylene group, tetramethylene group, pentamethylene group, hexamethylene group, etc. Examples of lower alkyl groups expressed by $R^5$, $R^6$, $R^7$ and $R^8$ are alkyl groups of 1 to 6 carbon atoms such as methyl group, ethyl group, propyl group, isopropyl group, butyl group, isobutyl group, tert-butyl group, pentyl group, hexyl group, etc. Examples of lower alkoxy group expressed by $R^5$, $R^6$, $R^7$ and $R^8$ are alkoxy groups of 1 to 6 carbon atoms such as methoxy, ethoxy, propoxy, isopropoxy, butoxy, isobutoxy, tert-butoxy, pentyloxy, hexyloxy group, etc.

Next, the polyimide precursor containing the polyamic acid units expressed by the formula (II) may be

obtained by reacting an organic tetracarboxylic dianhydride expressed by the following formula (IV) with an organic such as aromatic, aliphatic, etc. diamine expressed by the following formula (V), α,ω-diaminosiloxane, etc. in an organic solvent:

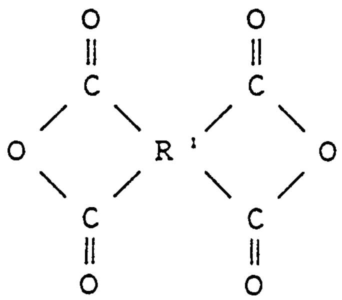

(IV)

$$H_2N-R^2-NH_2 \qquad (V)$$

wherein $R^1$ and $R^2$ are as defined above.

Representative examples of the organic tetracarboxylic dianhydride expressed by the formula (IV) are as follows, and these dianhydrides may be used alone or in admixture:
pyromellitic dianhydride,
benzene-1,2,3,4-tetracarboxylic dianhydride,
2,2',3,3'-benzophenonetetracarboxylic dianhydride,
2,3,3',4'-benzophenonetetracarboxylic dianhydride,
3,3',4,4'-benzophenonetetracarboxylic dianhydride,
2,2',3,3'-biphenyltetracarboxylic dianhydride,
3,3',4,4'-biphenyltetracarboxylic dianhydride,
2,3,3',4'-biphenyltetracarboxylic dianhydride,
2,3,6,7-naphthalenetetracarboxylic dianhydride,
3,4,9,10- perylenetetracarboxylic dianhydride,
2,3,6,7-anthracenetetracarboxylic dianhydride,
1,2,7,8-phenanthrenetetracarboxylic dianhydride,
bis(2,3-dicarboxyphenyl)methane dianhydride,
bis(3,4-dicarboxyphenyl)methane dianhydride,
1,2,5,6-naphthalenetetracarboxylic dianhydride,
2,2-bis(2,3-dicarboxyphenyl)propane dianhydride,
2,2-bis(3,4-dicarboxyphenyl)propane dianhydride,
1,1-bis(2,3-dicarboxyphenyl)ethane dianhydride,
bis(3,4-dicarboxyphenyl)sulfone dianhydride,
bis(3,4-dicarboxyphenyl)ether dianhydride,
3,3',4,4'-tetracarboxybenzoxybenzene dianhydride,
N,N-(3,4-dicarboxyphenyl)N-methylamine dianhydride,
thiophene-2,3,4,5-tetracarboxylic dianhydride,
pyrazine-2,3,5,6-tetracarboxylic dianhydride,
pyridine-2,3,5,6-tetracarboxylic dianhydride,
1,2,3,4-butanetetracarboxylic dianhydride,
pentanetetracarboxylic dianhydride,
1,2,3,4-cyclopentanetetracarboxylic dianhydride,
1,2,3,4-bicyclohexenetetracarboxylic dianhydride,
1,2,3,4-tetrahydrofurantetracarboxylic dianhydride,
1,2,3,4-cyclobutanetetracarboxylic dianhydride,
2,3,5-tricarboxycyclopentylacetic dianhydride, etc.

Further, as the organic diamine compound expressed by the formula (V), carbocyclic aromatic diamines, heterocyclic diamines, aliphatic diamines, alicyclic diamines, araliphatic diamines, etc. are mentioned and these amines may be used alone or in admixture.

Particular exmaples of the carbocyclic aromatic diamine are as follows:

o-, m- or p-phenylenediamine, diaminotoluenes such as 2,4-diaminotoluene, 1,4-diamino-2-methoxybenzene, 2,5-diaminoxylenes, 1,3-diamino-4-chlorobenzene, 1,4-diamino-2,5-dichlorobenzene, 1,4-diamino-2-bromobenzene, 1,3-diamino-4-isopropylbenzene, N,N'-diphenyl-1,4-phenylenediamine, 4,4'-diaminodiphenyl-2,2-propane, 4,4'-diaminodiphenylmethane, 2,2'-diaminostilbene, 4,4'-diaminostilbene, 4,4'-diaminodiphenyl ether, 4,4'-diaminodiphenyl thioether, 4,4'-diaminodiphenyl sulfone, 3,3'-diaminodiphenylsulfone, 4,4'-diaminobenzoic acid phenyl ester, 2,2'-diaminobenzophenone, 4,4'-diaminobenzophenone, 4,4'-diaminobenzyl, 4-(4'-aminophenylcarbamoyl)-aniline, bis(4-aminophenyl)-phosphinoxide, bis(4-aminophenyl)-methyl-phosphinoxide, bis(3-aminophenyl)-methylsulfinoxide, bis(4-aminophenyl)-phenylphosphinoxide, bis-(4-aminophenyl)-cyclohexylphosphinoxide, N,N-bis(4-aminophenyl)-N-phenylamine, N,N-bis(4-aminophenyl)-N-methylamine, 4,4'-diaminodiphenylurea, 1,8-diaminonaphthalene, 1,5-diaminonaphthalene, 1,5-diaminoanthraquinone, diaminofluoranthene, 4,4'-diaminobenzanilide, etc.

Examples of the heterocyclic diamines are as follows:

2,6-diaminopyridine, 2,4-diaminopyrimidine, 2,4-diamino-s-triazine, 2,7-diamino-dibenzofuran, 2,7-diaminocarbazole, 3,7-diaminophenothiazine, 2,5-diamino-1,3,4-triadiazole, etc.

Examples of the aliphatic diamines are as follows:

dimethylenediamine, trimethylenediamine, tetramethylenediamine, hexamethylenediamine, heptamethylenediamine, octamethylenediamine, nonamethylenediamine, decamethylenediamine, 2,2-dimethylpropylenediamine, 2,5-dimethylhexamethylenediamine, 2,5-dimethylheptamethylenediamine, 4,4-dimethylheptamethylenediamine, 3-methoxyhexamethylenediamine, 5-methylnonamethylenediamine, 2,11-diaminododecane, 1,12-diaminooctadecane, 1,2-bis(3-aminopropoxy)-ethane, N,N'-dimethyl-ethylene-diamine, N,N'-diethyl-1,3-diaminopropane, N,N'-dimethyl-1,6-diaminohexane, diamines expressed by the formula $H_2N(CH_2)_3O(CH_2)_2O(CH_2)_3NH_2$, diamines expressed by the formula $H_2N(CH_2)_3S(CH_2)_3NH_2$, etc.

Suitable examples of the alicyclic diamines are 1,4-diaminocyclohexane and 4,4'-diamino-dicyclohexylmethane. Suitable examples of araliphatic diamines are 1,4-bis(2-methyl-4-aminopentyl)-benzene, 1,4-bis-(1,1-dimethyl-5-aminopentyl)-benzene, 1,3-bis(aminomethyl)benzene and 1,4-bis(aminomethyl)-benzene.

Examples of the $\alpha,\omega$-diaminosiloxanes expressed by the formula (V) are as follows and these may be used alone or in admixture:

1,1,3,3-tetramethyl-1,3-bis(4-aminophenyl)disiloxane,
1,1,3,3-tetraphenoxy-1,3-bis(4-aminoethyl)disiloxane,
1,1,3,3,5,5-hexamethyl-1,5-bis(4-aminophenyl)trisiloxane,
1,1,3,3-tetraphenyl-1,3-bis(2-aminoethyl)disoloxane,
1,1,3,3-tetraphenyl-1,3-bis(3-aminopropyl)disiloxane,
1,1,5,5-tetraphenyl-3,3-dimethyl-1,5-bis(3-aminopropyl)trisiloxane,
1,1,5,5-tetraphenyl-3,3-dimethoxy-1,5-bis(4-aminobutyl)trisiloxane,
1,1,5,5-tetraphenyl-3,3-dimethoxy-1,5-bis(5-aminopentyl)trisiloxane,
1,1,3,3-tetramethyl-1,3-bis(2-aminoethyl)disiloxane,
1,1,3,3-tetramethyl-1,3-bis(3-aminopropyl)disiloxane,
1,1,3,3-tetramethyl-1,3-bis(4-aminobutyl)disiloxane,
1,3-dimethyl-1,3-dimethoxy-1,3-bis(4-aminobutyl)disiloxane,
1,1,5,5-tetramethyl-3,3-dimethoxy-1,5-bis(2-aminoethyl)trisiloxane,
1,1,5,5-tetramethyl-3,3-dimethoxy-1,5-bis(3-aminopropyl)trisiloxane,
1,1,5,5-tetramethyl-3,3-dimethoxy-1,5-bis(4-aminobutyl)trisiloxane,
1,1,5,5-tetramethyl-3,3-dimethoxy-1,5-bis(5-aminopentyl)trisiloxane,
1,1,3,3,5,5-hexamethyl-1,5-bis(3-aminopropyl)trisiloxane,
1,1,3,3,5,5-hexaethyl-1,5-bis(3-aminopropyl)trisiloxane,
1,1,3,3,5,5-hexapropyl-1,5-bis(3-aminopropyl)trisiloxane, etc.

The quantity of the $\alpha,\omega$-diaminosiloxanes used is 0.01 to 20 molar %, preferably 0.01 to 5 molar %, based upon the total quantity of the diamines.

With regard to the first layer polyimide having a coefficient of linear thermal expansion of $0.1 \times 10^{-5}$ to $2.0 \times 10^{-5}$ 1/° C, preferably exmaples of the acid anhydride among those described above are 3,3,4,4'-biphenyltetracarboxylic anhydride, pyromellitic anhydride, etc. and preferable examples of the diamine are p-phenylenediamine, 2,5-diaminotoluene, 4,4'-diaminobenzyl, etc. These may be used alone or in admixture.

Further, with regard to the second layer polyimide, its preferable examples are combinations of 3,3',4,4'-biphenyltetracarboxylic anhydride as the acid anhydride with p-phenylenediamine, 4,4'-diaminodiphenyl ether, $\alpha$-$\omega$-diaminosiloxane or the like as the diamine.

Examples of the organic solvent used at the time of the synthetic reaction of the polyimide precursors are as follows:

N,N-dimethylacetamide, N,N-diethylacetamide, N,N-dimethylformamide, N,N-dimethylmethoxyacetamide, N-methyl-2-pyrrolidone, N-acetyl-2-pyrrolidone, hexamethylphosphoric triamide, N-methylcaprolactam, N,N,N',N'-tetramethylurea, tetrahydrofuran, cyclohexanone, tetrahydrothiophene dioxide, dimethylsulfoxide, phenol, cresols, nitropropane, chloroform, xylene, toluene, cellosolves, carbitols, etc. These may be used alone or in admixture.

The organic solvents are preferred to be used so as to give a solid concentration of the reaction system of about 5 to 50% by weight, and also preferred to adjust the viscosity to about 500 to 500,000 centiposes.

The reaction of preparing the polyamic acid is exothermic, and if necessary, it is preferred to control the reaction under cooling. Namely, the reaction is carried out usually at about 0° to 60°C, preferably about 5° to 40°C. The organotetracarboxylic dianhydride and the organic diamine may be added at the same time. Further, a process of suspending or dissolving either one of them in an organic solvent, followed by reacting the other component while gradually adding it is also preferred. The molar ratio of the two components is preferred to be equimolecular, but even when either one of the components is used in an excess quantity within a range of about 10:9 to 9:10, no problem is raised.

As the polyimide precursor in its solution to be coated onto the metal foil, homopolymer, randum copolymer, block copolymer or mixtures thereof may be used.

As to the polyimides obtained by coating polyimide precursors onto a metal foil, followed by heat-imidization, in the present invention, the coefficients of thermal expansion of the respective layers are not always necessary to set the respective values so as to correspond to the value of the coefficient of thermal expansion of the metal foil, but the coefficient of thermal expansion of the polyimide contacted directly with the surface of the metal foil of the flexible base laminated with a metal on one of the surfaces needs to be within a range of about $0.1 \times 10^{-5}$ to $2.0 \times 10^{-5}/°C$.

Further, the coefficient of thermal expansion of the finally obtained,laminated polyimide film is about $0.1 \times 10^{-5}$ to $3.0 \times 10^{-5}/°C$, preferably about $1.5 \times 10^{-5}$ to $2.5 \times 10^{-5}/°C$. If the coefficient of thermal expansion exceeds the above range, the dimensional stability of the resulting flexible sheet laminated with metal is inferior.

The polyimide positioned on the surface layer of the flexible base laminated with metal on one of the surfaces, used in the present invention is necessary to be able to be sufficiently adhered onto another metal foil at the time of thermal contact bonding. Concretely, the polyimide is necessary to exhibit Tg at either point within 250° to 400°C as measured according to TMA and effect pseudoplasticization. If Tg is lower than the above temperature, the resulting flexible substrate laminated with metal on both the surfaces thereof is inferior in the heat resistance, while if it is higher than the above temperature, the contact bonding temperature overlaps with the decomposition temperature of the resin; hence such a temperature is not realistic.

As the metal foil used in the present invention, various metals such as copper, silver, iron, Ni-Cr alloy, etc. may be used, but there is no particular limitation thereto.

Further, the metal foil may be subjected to chemical or mechanical surface-treatment such as Ni-plating, treatment with aluminum alcoholate, aluminum chelate, silane coupling agent, etc.

The thickness of the metal foil is preferably in the range of about 5 μm to 1 mm. If it is less than the above range, the strength of the foil is practically too low to make difficult the steps of preparation of the foil itself, preparation of the flexible base laminated with metal, etc. If the thickness exceeds the above range, the flex becomes difficult; hence the merit of the flexible base laminated with metal is damaged.

As the process for applying a polyamic acid solution onto a metal foil in the present invention, there is exemplified a process of applying a solution containing about 1 to 50% by weight of a polyimide precursor onto a metal foil according to extrusion-casting process using roll coater, comma coater, knife coater, doctor blade, flow coater, closed coater, reverse coater, dice, gear, etc., but there is no particular limitation thereto.

The polyimide precursor solution applied as above is heat-dried at about 60 to 200°C, followed by coating the solution of a polyimide precursor having a different characteristic on the resulting material in the same manner as above,heat-drying at about 60° to 200°C, and further curing for imidization. The temperature of the curing for imidization is about 200° to 450°C, preferably about 300° to 430°C.

Drying and imidization of the coated polyimide precursors is preferably carried out in an atmosphere of an inert gas such as He, Ar, $N_2$, etc. in order to prevent the deterioration of the polyimide film and the metal conductor foil due to oxygen.

The thickness of the laminated polyimides in. the present invention is preferably about 1 to 500 μm. If it is less than the above range, it is difficult to obtain a coating accuracy, while if it exceeds the above range, foaming is liable to occur during the drying and imidization processes; hence such a thickness is undesirable.

The thus obtained flexible base laminated with metal on one surface is adhered onto another metal foil under thermal contact bonding to obtain a flexible base laminated with metals on both the surfaces.

As the heating method at the time of thermal contact bonding in the present invention, any of an equipment for contact bonding, the flexible base laminated with metal on one surface to be adhered and the metal foil may be heated, and it is preferred to simultaneously heat two kinds or more among the above.

As the heating method, electric heater, infrared-ray irradiation, steam, induction heating, microwave, dielectric heating, supersonic heating, etc. are exemplified.

As to the heating temperature, the temperatures applied to the flexible base laminated with metal on one surface and the metal foil to be adhered are preferred to be higher by about 30° to 250°C than Tg measured according to TMA of the surface layer polyimide of the flexible base laminated with metal on one surface. If the temperature is lower than the above range, a sufficient plastic deformation is difficult and there is a fear of being difficultly adhered, while if it exceeds the above range, there is a fear that the adhesion temperature overlaps with the decomposition temperature of the resin; hence such a temperature is undesirable.

As the contact bonding system, it is preferred to subject the flexible base laminated with metal on one surface and the metal foil to direct contact bonding according to a press system represented by roll press, flat plate press, etc. Further, in order to obtain a roll-form product continuously and efficiently by roll-to-roll, it is more preferred to employ roll process system.

The roll press machine used in the present invention is preferred to have a roll diameter of about 500 mm or less. If the roll diameter exceeds the above range, the pressure is difficultly applied in terms of linear pressure; hence such diameter is unsuitable to sufficient adhesion. The roll diameter has no particular lower limit, but about 20 mm is realistic. The linear pressure is preferred to be about 5 to 1,000 Kg/cm in terms of a value obtained by dividing the load applied onto the roll at the time of roll press by the width of contact bonding. If the pressure is lower than the above range, a sufficient adhesiveness cannot be obtained, while if it exceeds the above range, a practical adhesion is difficult in the sense of mechanical strength, and further, since elongation, deformation or breakage of the resin and metal foil occur, such a pressure is undesirable. The linear speed is preferably about 0.01 to 20 m/min. If it is lower than the above range, the production speed is very low and hence unpractical, while if it exceeds the above range, there is a fear that a sufficient adhesiveness cannot be obtained.

The flexible sheet laminated with metal on both the surfaces thereof is not only superior in the adhesion of the polyimide onto the metal foil, but also superior in the dimensional stability, heat resistance and electrical characteristics.

(Example)

The present invention will be described in more detail by way of Examples of the present invention and Comparative examples, but it should not be construed to be limited thereto.

In the Examples of the present invention and Comparative examples, the properties of the base were measured as follows:

Adhesion:

When the base laminated with copper foil on both the surfaces was cut to a width of 1 cm and the copper foil on the side where it was subjected to contact bonding was peeled off at an angle of 180°, the strength at that time was expressed by a value of unit of Kg/cm.

Dimensional stability:

This was measured according to JIS-C-6481. Two points were set on the base laminated with copper foil on both the surface, followed by measuring the distance therebetween, etching the base, removing the copper foils, drying the resulting material at 150°C for 30 minutes, allowing to stand at 21°C for 4 hours under a relative humidity of 50%, again measuring the distance between the two points and seeking the rate of change of distance according to the following equation (by %):

Dimensional stability (%) = ((measurement value of film obtained by base etching and foil removal - measurement value of base laminated on both the surfaces)/(measurement value of base laminated on both the surfaces)) $\times$ 100

Coefficient of linear thermal expansion:

Using as a sample, the polyimide film obtained by etching the base and removing the copper foil, the quantity of expansion of from 100°C up to 250°C and the length at 25°C were measured by means of TMA, followed by calculating the coefficient according to the above-mentioned method.

Electrical characteristics:

According to JIS-C-6481, a parallel pattern of a distance between lines of 1.0 mm and a total extended length of 80 mm was formed by etching, followed by impressing DC 100V upon the resulting material and seeking the insulation resistance between lines after lapse of one minute, as expressed in terms of Ω.

Heat resistance:

The base laminated on both the surfaces was immersed in a bath of molten solder, at 350°C for one minute, to visibly observe the presence or absence of abnormalities such as foaming, peeling, etc. A product having no abnormality was regarded as acceptable.
The pressure cooker test was carried out as follows:
The base laminated on both the surfaces thereof was cut to a width of 1 cm, followed by treating the cut sample at 121°C, under 2 atm, in saturated steam, for 1,000 hours and measuring the peel strength of the adhered surfaces.

Preparation example 1

Into a 2 ℓ capacity reaction vessel equipped with a thermometer, a stirrer and a nitrogen gas-blowing-in port, under blowing of nitrogen gas of 50 mℓ/min there-into, were fed p-phenylenediamine (hereinafter abbreviated to p-PDA) (47.43 g, 0.439 mol) as a diamine component and N,N-dimethylacetamide (1,000 g) as a solvent for preparation, followed by gradually adding 3,3',4,4'-biphenyltetracarboxylic dianhydride (hereinafter abbreviated to s-BPDA) (129.03 g, 0.439 mol) as an acid anhydride under cooling at 20°C, and subjecting the mixture to polymerization reaction for 6 hours to obtain a polyimide precursor solution (I) having a solid concentration of 15% by weight.

This polyimide precursor solution (I) had a viscosity of 56,000 cps. This solution (I) was cast-coated onto a copper foil (JTC 35 µm,trade name of a product made by Nippon Mining Co., Ltd.; hereinafter this product was used as copper foil in Preparation examples, Examples and Comparatice examples), so as to give a thickness of a film after heat-imidization of 30 µm, drying the resulting material at 100°C for 10 minutes, raising the temperature up to 350°C over one hour, curing for imidization at 350°C for 30 minutes to obtain a flexible base laminated with copper on one surface thereof.

The copper foil was etched with a ferric chloride solution to obtain a polyimide film, followed by measuring the Tg of the polyimide film by means of TMA. As a result, the Tg was absent within a range of 25° to 550°C. Further, its coefficient of linear thermal expansion was analyzed similarly by means of TMA to give $1.5 \times 10^{-5}/°C$.

Preparation example 2

Preparation example 1 was repeated except that 4,4'-diaminodiphenyl ether (hereinafter abbreviated to DDA) (71.46 g, 0.357 mol) was used as a diamine component and s-BPDA (105.00 g, 0.357 mol) was used as an acid anhydride, to obtain a polyimide precursor solution (II) having a viscosity of 48,000 cps. A polyimide film obtained from the polyimide precursor solution (II) in the same manner as in Preparation example 1 exhibited a Tg of 290°C as measured by means of TMA and a coefficient of linear thermal expansion of $3.3 \times 10^{-5}/°C$.

Preparation exmaple 3

Preparation example 1 was repeated except that DDE (84.46 g, 0.422 mol) was used as a diamine component and pyromellitic dianhydride (hereinafter abbreviated to PMDA) (92.01 g, 0.422 mol) was used as an acid anhydride component, to obtain a polyimide precursor solution (III) having a viscosity of 43,000 cps. A polyimide film obtained from the polyimide precursor solution (III) in the same manner as in Preparation example 1 exhibited no Tg as measured by means of TMA, within a range of 25° to 550°C. Further, its coefficient of linear thermal expansion analyzed in the same manner was $3.3 \times 10^{-5}/°C$.

Preparation example 4

Preparation example 1 was repeated except that p-PDA (16.68 g, 0.154 mol) and DDE (46.33 g, 0.231 mol) were used as diamine component and s-BPDA (113.46 g, 0.386 mol) was used as an acid anhydride component, to obtain a polyimide precursor solution (IV) having a viscosity of 55,000 cps. A polyimide film obtained from the precursor solution (IV) in the same manner as in Preparation example 1 exhibited a Tg as measured by means of TMA, of 300 ° C. Further its coefficient of linear thermal expansion was 3.1 $\times 10^{-5}/°C$.

Preparation example 5

Preparation example 1 was repeated except that 4,4'-diaminobenzanilide (hereinafter abbreviated to DABAN) (90.04 g, 0.396 mol) was used as a diamine component and PMDA (86.42 g, 0.396 mol) was used as an acid anhydride component, to obtain a preimide precursor solution (V) having a viscosity of 50,000 cps. A polyimide film obtained from the precursor solution (V) in the same manner as in Preparation exmaple 1 exhibited no Tg as measured by means of TMA, within a range of 25° to 550° C. Further, its coefficient of linear thermal expansion was 0.8 $\times 10^{-5}/°C$.

Preparation example 6

Preparation example 1 was repeated except that 2'-methoxy-4,4'-diaminobenzanilide (28.30 g, 0.110 mol) and 4,4'-diaminodiphenyl ether (22.03 g, 0.110 mol) were used as the diamine component and pyromellitic anhydride (47.84 g, 0.219 mol) was used as the acid anhydride, to obtain a polyimide precursor solution (VI) having a viscosity of 30,000 cps. A polyimide film prepared from the precursor solution (VI) in the same manner as in Preparation example 1 exhibited a coefficient of linear thermal expansion of 1.2 $\times 10^{-5}/°C$.

Preparation exmaple 7

Preparation example 1 was repeated except that 3,3'-diaminodiphenylsulfone (20.00 g, 0.081 mol) was used as the diamine compound and 3,3',4,4'-benzophenonetetracarboxylic anhydride (25.9 g, 0.081 mol) was used as the acid anhydride, to obtain a polyimide precursor solution (VII) having a viscosity of 20,000 cps. A polyimide film prepared from the precursor solution (VII) in the same manner as in Preparation example 1 exhibited a coefficient of linear thermal expansion of 5.0 $\times 10^{-5}/°C$.

Example 1

(1) Base laminated on one surface:

Polyimide precursor solution (I) was cast-coated onto a copper foil (JTC 35 μ) so as to give a film thickness of 24 μm after heat-imidization, followed by drying the resulting material at 80 ° C for 5 minutes, cast-coating the polyimide precursor solution (IV) on its upper layer, so as to give a film thickness of 6 μm after heat imidization, drying the resulting material at 100 ° C for 10 minutes, raising the temperature up to 350 ° C over one hour and curing for imidization at 350 ° C for 30 minutes, to obtain a flexible base laminated with copper on one surface. A polyimide film was then obtained in the same manner as in Preparation example 1, followed by measuring its coefficient of linear thermal expansion by means of TMA, to exhibit 2.0 $\times 10^{-5}/°C$.

(2) Base laminated on both the surfaces:

A copper foil (JTC 35 μ) was superposed upon the resin surface of the base laminated on one surface, obtained in the above item (1), followed by subjecting the both to thermal contact bonding by means of heated roller press under the conditions shown in Table 1, continuously preparing a base laminated on both the surfaces and measuring its properties. The results are shown in Table 1.

Examples 2 and 3

Example 1 was repeated except that a copper foil (JTC 35 μ) was superposed onto the base laminated on one surface obtained in the item (1) of Example 1 under the conditions shown in Table 1, followed by subjecting the both to contact bonding by means of heated roller press and continuously preparing bases laminated on both the surfaces and measuring their properties. The results are shown in Example 2 and 3

in Table 1.

Example 4

The polyimide precursor solution (I) was cast-coated onto a copper foil (JTC 35 μ) so as to give a film thickness after heat-imidization of 21 μm, followed by drying the both at 80 ° C for 5 minutes, cast-coating the polyimide precursor solution (II) on its upper layer, so as to give a film thickness of 9 μm after heat imidization, drying the resulting material at 100 ° C for 10 minutes, raising the temperature up to 350 ° C over one hour and curing for imidization at 350 ° C for 30 minutes, to obtain a flexible base laminated with copper on one surface. A polyimide film was then obtained in the same manner as in Preparation example 1, followed by measuring its coefficient of linear thermal expansion by means of TMA, to exhibit $1.8 \times 10^{-5}$/ ° C.

A copper foil (JTC 35 μ) was superposed onto the resin surface of the base laminated on one surface obtained in the above item (1), followed by subjecting the both to thermal contact bonding by means of heated roller press under the conditions shown in Table 1, continuously preparing a base laminated on both the surfaces and measuring its properties. The results are shown in Table 1.

Example 5

A polyimide precursor solution (V) was cast-coated onto a copper foil (JTC 35 μ) so as to give a film thickness of 18 μm after heat-imidization, followed by drying the both at 80 ° C for 5 minutes, cast-coating onto the upper layer, the polyimide precursor solution (II) so as to give a film thickness of 12 μm after heat-imidization, drying at 100 ° C for 10 minutes, raising the temperature up to 350 ° C over one hour, and curing for imidization at 350 ° C for 30 minutes to obtain a flexible base laminated with copper on one surface. A polyimide film was then obtained in the same manner as in Preparation exmaple 1, followed by measuring its coefficient of linear thermal expansion by means of TMA, to give $2.0 \times 10^{-5}$/ ° C within a range of 100 ° to 250 ° C.

A copper foil (JTC 35 μ) was superposed onto the base laminated on one surface obtained in the above item (1), followed by subjecting the both to thermal contact bonding by means of heated roller press under the conditions shown in Table 1, continuously preparing a base laminated onto both the surfaces and measuring its properties. The results are shown in Table 1.

Comparative example 1

Example 1 was repeated except that a copper foil (JTC 35 μ) was superposed onto the resin surface of the base laminated on one surface, obtained in the item (1) of Example 1, and the conditions shown in Table 1 were employed, followed by subjecting the both to contact bonding by means of heated roller press, continuously preparing a base laminated on both the surfaces and measuring its properties. The results are shown in Table 1.

Comparative example 2

A polyimide precursor solution (I) was cast-coated onto a copper foil (JTC 35 μ) so as to give a film thickness of 30 μm after heat-imidization, followed by drying the both at 100 ° C for 10 minutes, raising the temperature up to 350 ° C over one hour and curing for imidization at 350 ° C for 30 minutes to obtain a base laminated with copper on one surface.

A copper foil (JTC 35 μ) was superposed onto the resin surface of the base laminated onto one surface, followed by subjecting the both to thermal contact bonding by means of heated roller press under the conditions shown in Table 1, continuously preparing a base laminated on both the surfaces and measuring its properties. The results are shown in Table 1.

Comparative example 3

A polyimide precursor solution (II) was cast-coated onto a copper foil (JTC 35 μ) so as to give a film thickness of 30 μm after heat-imidization, followed by drying the both at 100 ° C for 10 minutes, raising the temperature up to 350 ° C over one hour and curing for imidization at 350 ° C for 30 minutes to obtain a flexible base laminated with copper on one surface.

The resin surface of the base laminated on one surface was superposed onto a copper foil (JTC 35 μ),

followed by subjecting the both to thermal contact bonding by means of heated roll press under the conditions shown in Table 1, continuously preparing a base laminated on both the surfaces and measuring its properties. The results are shown in Table 1.

Comparative example 4

A polyimide precursor solution (III) was cast-coated onto a copper foil (JTC 35 μ) so as to give a film thickness of 30 μm after heat-imidization, followed by drying at 100°C for 10 minutes, raising the temperature up to 350°C over one hour and curing for imidization at 350°C for 30 minutes to obtain a flexible base laminated with copper on one surface.

The resin surface of the base laminated on one surface was superposed onto a copper foil (JTC 35 μ) followed by subjecting the both to thermal contact bonding by means of heated roller press, under the conditions shown in Table 1, continuously preparing a base laminated on both the surfaces and measuring its properties. The results are shown in Table 1.

Comparative example 5

A polyimide precursor solution (IV) was cast-coated onto a copper foil (JTC 35 μm) so as to give a film thickness of 30 μm after heat-imidization, followed by drying at 100°C for 10 minutes, raising the temperature up to 350°C for one hour, curing for imidization at 350°C for 30 minutes to obtain a flexible base laminated with copper on one surface thereof.

The resin surface of the base laminated on one surface was superposed onto a copper foil (JTC 35 μ), followed by subjecting the resulting material to thermal contact bonding by means of heated roller press under the conditions shown in Table 1, continuously preparing a base laminated on both the surfaces and measuring its properties. The results are shown in Table 1.

As seen from the above Examples and Comparative exmaples, Examples are superior in any of the physical properties, whereas Comparative examples 1, 2 and 4 are inferior in the adhesion and Comparative examples 3 and 5 are inferior in the dimensional stability.

Comparative example 6

A polyimide precursor solution (VI) was cast-coated onto a film so as to give a film thickness after heat-imidization of 24 μm, followed by heating at 130°C for 10 minutes, thereafter cast-coating a polyimide precursor solution (VII) onto the resin layer of the resulting material so as to give a film thickness after heat-imidization of 6 μm, heating the resulting material at 130°C and 160°C, each for 10 minutes, raising the temperature up to 350°C over one hour and curing for imidization at 350°C for 30 minutes, to obtain a base laminated with copper on one side thereof. The coefficient of linear thermal expansion of the polyimide film was measured in the same manner as in Preparation example 1, to exhibit $1.5 \times 10^{-5}$ /°C.

Next, two of this base laminated with copper on one side were superposed so that the respective resin layers might be contacted with each other, followed by subjecting the resulting material to heated roller press to carry out thermal contact bonding at 1,500 Kg, 0.2 m/min, in the same manner as in Example 1 and thereby obtain a base laminated with copper on both the surfaces thereof. Its properties were then measured. The results are shown in Table 1.

Table 1

| No. | Tg (°C) of surface layer resin of flexible base laminated with Cu on one surface (°C) | Conditions of contact bonding | | | | | Adhesiveness (contact bonded surface) Kg/cm | Dimensional stability (%) | Coefficient of linear thermal expansion ( /°C) | Electrical properties (Ω) | Heat resistance 350℃, 1 min | Pressure Cooker test (Kg/cm) |
|---|---|---|---|---|---|---|---|---|---|---|---|---|
| | | Roll diameter (mm) | Roll width (mm) | Temperature (°C) | Roll load (kg) | Speed (m/min) | | | | | | |
| Example 1 | 300 | 100 | 300 | 400 | 1,500 | 0.2 | 1.5 | 0.11 | $2.0\times10^{-5}$ | $3\times10^{12}$ | OK | 1.4 |
| 2 | 300 | 250 | 500 | 400 | 3,500 | 0.3 | 1.4 | 0.08 | $2.0\times10^{-5}$ | $5\times10^{12}$ | OK | 1.3 |
| 3 | 300 | 350 | 800 | 400 | 30,800 | 0.5 | 1.2 | 0.10 | $2.0\times10^{-5}$ | $5\times10^{12}$ | OK | 1.2 |
| 4 | 290 | 100 | 300 | 400 | 1,500 | 0.2 | 1.8 | 0.07 | $1.8\times10^{-5}$ | $3\times10^{12}$ | OK | 1.6 |
| 5 | 290 | 100 | 300 | 400 | 1,500 | 0.2 | 1.8 | 0.10 | $2.0\times10^{-5}$ | $2\times10^{12}$ | OK | 1.6 |
| Comp. ex. 1 | 300 | 100 | 300 | 280 | 1,500 | 0.2 | 0 | - a) | $2.0\times10^{-5}$ | - a) | - a) | -a) |
| 2 | None | 100 | 300 | 500 | 1,500 | 0.2 | 0 | - a) | $1.5\times10^{-5}$ | - a) | - a) | -a) |
| 3 | 290 | 100 | 300 | 400 | 1,500 | 0.2 | 2.0 | 0.50 | $3.3\times10^{-5}$ | $2\times10^{12}$ | OK | 1.8 |
| 4 | None | 100 | 300 | 400 | 1,500 | 0.2 | 0.17 | - a) | $3.3\times10^{-5}$ | - a) | - a) | 0.1 |
| 5 | 300 | 100 | 300 | 400 | 1,500 | 0.2 | 1.5 | 0.30 | $3.1\times10^{-5}$ | $3\times10^{12}$ | OK | 1.4 |
| 6 | 280 | 100 | 300 | 400 | 1,500 | 0.2 | 0.3 b) | 0.08 | $1.5\times10^{-5}$ | $4\times10^{12}$ | OK | b) |

a): Unmeasurable due to inferior adhesiveness

b): Peeled off on the surfaces of polyimides

(Effectiveness of the Invention)

As to the flexible base laminated with a metal on both the surfaces of the present invention, by combining a polyimide having a superior coefficient of linear thermal expansion with a polyimide pseudoplasticized by heating within a definite temperature range, the flexible sheet has a highly balanced adhesion and dimensional stability and also superior heat resistance and electrical properties.

Further, according to the process of the present invention, it is possible to obtain a flexible base laminated on both the surfaces of continuous length in a simple manner and continuously.

When the flexible base laminated on both the surfaces of the present invention is used for printed circuit, a product having a superior reliability to that of conventional flexible bases laminated with metal is not only obtained, but also the product can be produced continuously and effectively; hence the process is advantageous in the aspect of cost.

**Claims**

**1.** A flexible base laminated with a metal on both the surfaces thereof, comprising a resin layer consisting of two laminated polyimide layers formed directly between two metal conductive foils,

the first layer of said two laminated polyimide layers having a coefficient of linear thermal expansion of about $0.1 \times 10^{-5}$ to $2.0 \times 10^{-5}/°C$,

the second layer thereof having a glass transition point (Tg) of about 250 to 400 °C as measured according to thermomechanical analysis (hereinafter referred to as TMA) and

the polyimide laminated having a coefficient of linear thermal expansion of about $1.0 \times 10^{-5}$ to $3.0 \times 10^{-5}/°C$.

**2.** A process for producing a flexible base laminated with a metal on both the surfaces thereof according to claim 1, comprising firstly coating onto a metal conductive foil, a solution of a polyimide precursor which, after imidized, affords a resin having a coefficient of linear thermal expansion of about $0.1 \times 10^{-5}$ to $2.0 \times 10^{-5}/°C$, followed by drying the resulting laminate, coating onto the dried laminate, a solution of another polyimide precursor which, after imidized, affords a resin having a Tg of about 250° to 400 °C as measured according to TMA, imidizing the resulting laminate by heat treatment to prepare a flexible base laminated with a metal on one surface thereof, the above-mentioned two kinds of the polyimide precursors being chosen so that the thus obtained polyimide laminate may have a coefficient of linear thermal expansion of about $1.0 \times 10^{-5}$ to $3.0 \times 10^{-5}/°C$, and subjecting the resin surface of the resulting base to thermal contact bonding onto another metal conductive foil.

**3.** A process according to claim 2 , wherein said thermal contact bonding is continuously carried out according to roll-to-roll system by means of a roll press.

European Patent Office

# EUROPEAN SEARCH REPORT

Application Number

EP 92 10 0875

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 335 337 (NIPPON STEEL CHEMICAL CO. LTD.)<br>* claims 1,8,9; examples 1-6 *<br>--- | 1-3 | B32B15/01 |
| X | EP-A-0 249 744 (AKZO N.V.)<br>* example 10 *<br>--- | 1-3 | |
| A | US-A-4 916 009 (HINO ET AL)<br>* claims *<br>--- | 1-3 | |
| P,A | EP-A-0 411 772 (CHISSO CORPORATION)<br>* claims *<br>----- | 1-3 | |
| | | | TECHNICAL FIELDS SEARCHED (Int. Cl.5) |
| | | | B32B<br>H05K |

The present search report has been drawn up for all claims

| Place of search | Date of completion of the search | Examiner |
|---|---|---|
| THE HAGUE | 08 APRIL 1992 | DE JONGE S.J.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................
& : member of the same patent family, corresponding document

EPO FORM 1503 03.82 (P0401)